# EUROPEAN PATENT SPECIFICATION

(11) **EP 1 435 115 B1**
(45) Date of publication and mention of the grant of the patent: **04.10.2017**
(21) Application number: 02794662.3
(22) Date of filing: 05.08.2002
(51) Int. Cl.: H01L 29/78, H01L 29/423, H01L 21/336

(54) **MIS DEVICE HAVING A TRENCH GATE ELECTRODE AND METHOD OF MAKING THE SAME**
MIS-ANORDNUNG MIT GRABEN-GATEELEKTRODE UND VERFAHREN ZU DEREN HERSTELLUNG
DISPOSITIF METAL-ISOLANT-SEMICONDUCTEUR, MIS, À GRILLE EN TRANCHÉE ET PROCEDE DE FABRICATION ASSOCIE

(30) Priority: 10.08.2001 US 927143; 26.03.2002 US 106812; 26.03.2002 US 106896
(43) Date of publication of application: 07.07.2004
(73) Proprietor: SILICONIX Incorporated, Santa Clara, California 95054 (US)
(72) Inventor: DARWISH, Mohamed, N., Campbell, CA 95060 (US); YUE, Christina, Milpitas, CA 95035 (US); GILES, Frederick, P., San Jose, CA 95118 (US); LUI, Kam Hong, Santa Clara, CA 95051 (US); CHEN, Kuo-In, Los Altos, CA 94024 (US); TERRILL, Kyle, Santa Clara, CA 95050 (US); PATTANAYAK, Deva, N., Cupertino, CA 95014 (US)
(74) Representative: Puschmann Borchert Bardehle Patentanwälte Partnerschaft mbB
(86) International application number: PCT/US2002/024782
(87) International publication number: WO 2003/015180

(56) References cited:
- EP-A- 0 801 426
- EP-A2- 1 162 665
- US-A- 5 424 231
- US-A1- 2003 030 092
- PATENT ABSTRACTS OF JAPAN vol. 013, no. 483 (E-839), 2 November 1989 (1989-11-02) -& JP 01 192174 A (HITACHI LTD), 2 August 1989 (1989-08-02)
- PATENT ABSTRACTS OF JAPAN vol. 015, no. 486 (E-1143), 10 December 1991 (1991-12-10) -& JP 03 211885 A (MATSUSHITA ELECTRON CORP), 17 September 1991 (1991-09-17)
- PATENT ABSTRACTS OF JAPAN vol. 1999, no. 11, 30 September 1999 (1999-09-30) -& JP 11 163342 A (NEC CORP), 18 June 1999 (1999-06-18)

## Description

This invention relates to trench metal-insulator-semiconductor (MIS) devices and a method for producing the same.

Some metal-insulator-semiconductor (MIS) devices include a gate located in a trench that extends downward from the surface of a semiconductor substrate (e. g., silicon). The current flow in such devices is primarily vertical and, as a result, the cells can be more densely packed. All else being equal, this increases the current carrying capability and reduces the on-resistance of the device. Devices included in the general category of MIS devices include metal-oxide-semiconductor field effect transistors (MOSFETs), insulated gate bipolar transistors (IGBTs), and MOS-gated thyristors.

Trench MOSFETs, for example, can be fabricated with a high transconductance (gm, max) and low specific on resistance (Ron), which are important for optimal linear signal amplification and switching. One of the most important issues for high frequency operation, however, is reduction of the MOSFET internal capacitances. The internal capacitances include the gate-to-drain capacitance (Cgd), which is also called the feedback capacitance (Crss), the input capacitance (CsSs), and the output capacitance (Coss).

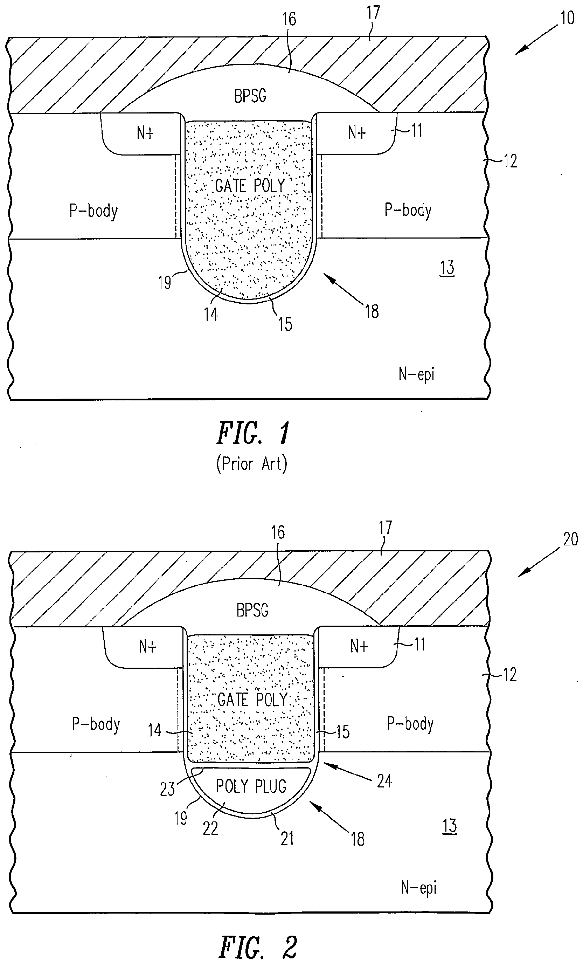

Fig. 1 is a cross-sectional view of a conventional n type trench MOSFET 10. In MOSFET 10, an n-type epitaxial ("N-epi") layer 13, which is usually grown on an N+ substrate (not shown), is the drain. N-epi layer 13 may be a lightly doped layer, that is, an N-layer. A p-type body region 12 separates N-epi layer 13 from N+ source regions 11. Current flows vertically through a channel (denoted by the dashed lines) along the sidewall of a trench 19. The sidewall and bottom of trench 19 are lined with a thin gate insulator 15 (e. g. , silicon dioxide). Trench 19 is filled with a conductive material, such as doped polysilicon, which forms a gate 14. Trench 19, including gate 14 therein, is covered with an insulating layer 16, which may be borophosphosilicate glass (BPSG). Electrical contact to source regions 11 and body region 12 is made with a conductor 17, which is typically a metal or metal alloy. Gate 14 is contacted in the third dimension, outside of the plane of Fig. 1.

A significant disadvantage of MOSFET 10 is a large overlap region 18 formed between gate 14 and N-epi layer 13, which subjects a portion of thin gate insulator 15 to the drain operating voltage. The large overlap limits the drain voltage rating of MOSFET 10, presents long term reliability issues for thin gate insulator 15, and greatly increases the gate-to-drain capacitance, Cgd, of MOSFET 10. In a trench structure, Cgd is larger than in conventional lateral devices, limiting the switching speed of MOSFET 10 and thus its use in high frequency applications.

One possible method to address this disadvantage is described in document EP 1162665 A2 and is illustrated in Fig. 2. Fig. 2 is a cross sectional view of a trench MOSFET 20 with an undoped polysilicon plug 22 near the bottom of trench 19. MOSFET 20 is similar to MOSFET 10 of Fig. 1, except for polysilicon plug 22, which is isolated from the bottom of trench 19 by oxide layer 21 and from gate 14 by oxide layer 23. The sandwich of oxide layer 21, polysilicon plug 22, and oxide layer 23 serves to increase the distance between gate 14 and N-epi layer 13, thereby decreasing Cgd. In some situations, however, it may be preferable to have a material even more insulating than undoped polysilicon in the bottom of trench 19 to minimize Cgd for high frequency applications.

One possible method to address this issue is described in the document WO 03/015179 A2 and is illustrated in Fig. 3. Fig. 3 is a cross-sectional view of a trench MOSFET 30 with a thick insulating layer 31 near the bottom of trench 19.

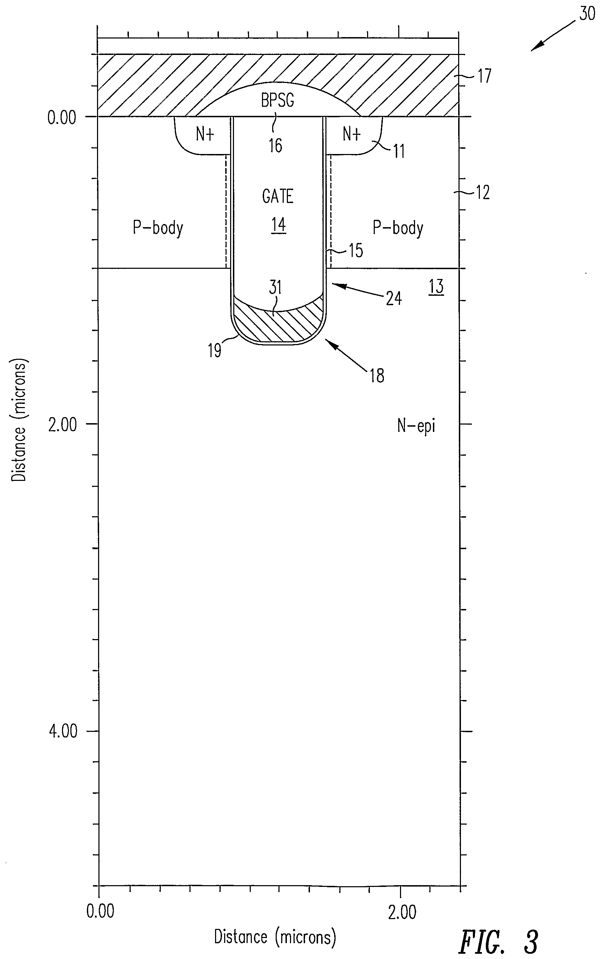

MOSFET 30 is similar to MOSFET 10 of Fig. 1 and MOSFET 20 of Fig. 2. In MOSFET 30, however, only the sidewall of trench 19 is lined with thin gate insulator 15 (e. g., silicon dioxide). Unlike MOSFET 10 of Fig. 1, a thick insulating layer 31 (e. g. , silicon dioxide) lines the bottom of trench 19 of MOSFET 30 of Fig. 3. Thick insulating layer 31 separates gate 14 from N-epi layer 13. This circumvents the problems that occur when only thin gate insulator 15 separates gate 14 from N-epi layer 13 (the drain) as in Fig. 1. Thick insulating layer 31 provides a more effective insulator than is achievable with polysilicon plug 22 as shown in Fig. Thick insulating layer 31 decreases the gate-todrain capacitance, Cgd, of MOSFET 30 compared to MOSFET 20 of Fig. 2.

The solution of Fig. 3 has a thin gate oxide region 24 between body region 12 and thick insulating layer 31. This is because the bottom interface of body region 12 and the top edge of thick insulating layer 31 are not self-aligned. If body region 12 extends past the top edge of thick insulating layer 31, MOSFET 30 could have a high on-resistance, Ron, and a high threshold voltage. Since such alignment is difficult to control in manufacturing, sufficient process margin can lead to significant gate-to-drain overlap in thin gate oxide regions 24. Thin gate region 24 also exists in MOSFET 20 of Fig. 2, between body region 12 and polysilicon plug 22. Thus, Cgd can still be a problem for high frequency applications.

It is the purpose of JP 1192174 A not only to improve a device in breakdown strength but also micronize a cell in size by a method wherein a trench is provided so as to reach to a drain region, a gate oxide film is formed on the inner wall of the trench, and the oxide film formed on the base of the trench is made thicker than one formed on the side wall or other parts of the trench. To this end, a source region is formed on a primary face of a semiconductor substrate in a grating. A trench (deep groove) is provided along a center of the source region. The base of the trench reaches an epitaxial layer or a superficial layer of the semiconductor substrate penetrating a channel forming layer. A gate oxide film is provided covering the inner wall of the trench. The gate oxide film is 50 nm (500 Angstrom) in thickness at the side wall of the trench and 200 nm - 300 nm (2000 Angstrom-3000 Angstrom) thick at the base of the trench. A device of this design is formed in such a structure that the gate oxide film is provided onto the wall of the trench and a gate electrode buried in the trench, so that the cell can be diminished in size. A gate oxide film formed on the base of a trench is made thick, wherefore an electric field between a gate and a drain is alleviated and the drain is improved in breakdown strength

It is the purpose of JP 11163342 (A) to actualize the semiconductor device which is reduced in gate electrode resistance and on-resistance, as to a longitudinal field effect transistor having a trench groove. The semiconductor device which has a first diffusion layer of second conductivity type and a second diffusion layer of a first conductivity type formed doubled on the surface part of a first conductivity type semiconductor substrate or first conductivity type epitaxial layer, has a trench groove where a gate oxide film and a gate electrode are embedded on the surface and also has a channel arranged longitudinally along the depth of the trench groove is constituted by etching part of the gate electrode 6 along the depth of the trench groove and thus forming a hollow part, and then embedding an oxide film layer thicker than the gate oxide film at the bottom part of the hollow part and further metal with conductivity larger than that of the gate electrode on it.

US-A-5,424,231 refers to a VDMOS transistor having a reduced drain/source resistance without a corresponding decrease in breakdown voltage and a manufacturing method therefore. Such a VDMOS transistor is created by gradually increasing the doping density of the transistor's implanted regions, while simultaneously increasing the respective thicknesses of the gate oxide layers corresponding to the implanted regions along the current flow path.

It is an object of the invention to provide a trench MOSFET with decreased gate-to-drain capacitance, Cgd, and better high frequency performance a method of fabricating the same. For this purpose, the trench MIS device of the invention comprises the features of claim 1 or 9, whereas the method of the invention comprises the features of claim 11 and 18. Preferred embodiments of the invention are characterized in the sub-claims.

In accordance with a preferred embodiment of the present invention, a metal-insulator-semiconductor (MIS) device includes a semiconductor substrate including a trench extending into the substrate from a surface of the substrate. A source region of a first conductivity type is adjacent to a sidewall of the trench and to the surface of the substrate. A body region of a second conductivity type opposite to the first conductivity type is adjacent to the source region and to the sidewall and to a first portion of a bottom surface of the trench. A drain region of the first conductivity type is adjacent to the body region and to a second portion of the bottom surface of the trench. The trench is lined with a first insulating layer at least along the sidewall that abuts the body region and at least along the first portion of the bottom surface that abuts the body region. The trench is also lined with a second insulating layer along the second portion of the bottom surface of the trench. The second insulating layer is coupled to the first insulating layer, and the second insulating layer is thicker than the first insulating layer.

In an exemplary embodiment of a fabrication process for such an MIS device, a trench including a sidewall, a corner surface, and a central bottom surface is formed in a substrate. A thick insulating layer is deposited on the central bottom surface. A thin insulating layer is formed on the sidewall and on the corner surface. A gate is formed around and above the thick insulating layer and adjacent to the thin insulating layer in the trench, so as to form an active corner region along at least a portion of the corner surface.

In one embodiment, the thick insulating layer is deposited using a mask layer that is deposited and etched to expose a central portion of the bottom surface of the trench.

The thick insulating layer is deposited and etched to form an exposed portion of the mask layer on the sidewall, leaving a portion of the thick insulating layer on the central portion of the bottom surface of the trench. The mask layer is removed, exposing the sidewall and the corner surface of the trench, while leaving the portion of the thick insulating layer on the central portion of the bottom surface of the trench.

The thick insulating layer separates the trench gate from the drain conductive region at the bottom of the trench, while the active corner regions minimize the gate-todrain overlap in thin gate insulator regions. This results in a reduced gate-to-drain capacitance, making MIS devices in accordance with the present invention, such as trench MOSFETs, suitable for high frequency applications.

In an alternative embodiment, the trench is lined with an oxide layer. The oxide layer comprises a first section, a second section and a transition region between said first and second sections. The first section is adjacent at least a portion of the drain region of the device, and the second section is adjacent at least a portion of the body region of the device. The thickness of the oxide layer in said first section is greater than the thickness of said oxide layer in the second section. The thickness of the oxide layer in the transition region decreases gradually from the first section to the second section. A PN junction between the body region and the drain region terminates at the trench adjacent said transition region of said oxide layer.

This invention will be better understood by reference to the following description and drawings. In the drawings, like or similar features are typically labeled with the same reference numbers.
Fig. 1 is a cross-sectional view of a conventional trench MOSFET.
Fig. 2 is a cross-sectional view of a trench MOSFET with a polysilicon plug at the bottom of the trench.
Fig. 3 is a cross-sectional view of a trench MOSFET with a thick insulating layer at the bottom of the trench.
Fig. 4 is a cross-sectional view of one embodiment of a trench MOSFET in accordance with the present invention.
Figs. 5A-5P are cross-sectional views illustrating one embodiment of a process for fabricating a trench MOSFET in accordance with the present invention.
**Fig. 6** is a cross-sectional view of an alternative embodiment of a trench MOSFET in accordance with the present invention.
**Fig. 7** is a cross-sectional view of an alternative embodiment of a trench MOSFET in accordance with the present invention.
**Fig. 8** is a cross-sectional view taken during the fabrication of yet another alternative embodiment
**Figs. 9A-9C** show three variations of the embodiment of **Fig. 8****.**
**Fig. 10** is a cross-sectional view of the completed MIS device of **Fig. 8****.**

### DESCRIPTION OF THE INVENTION

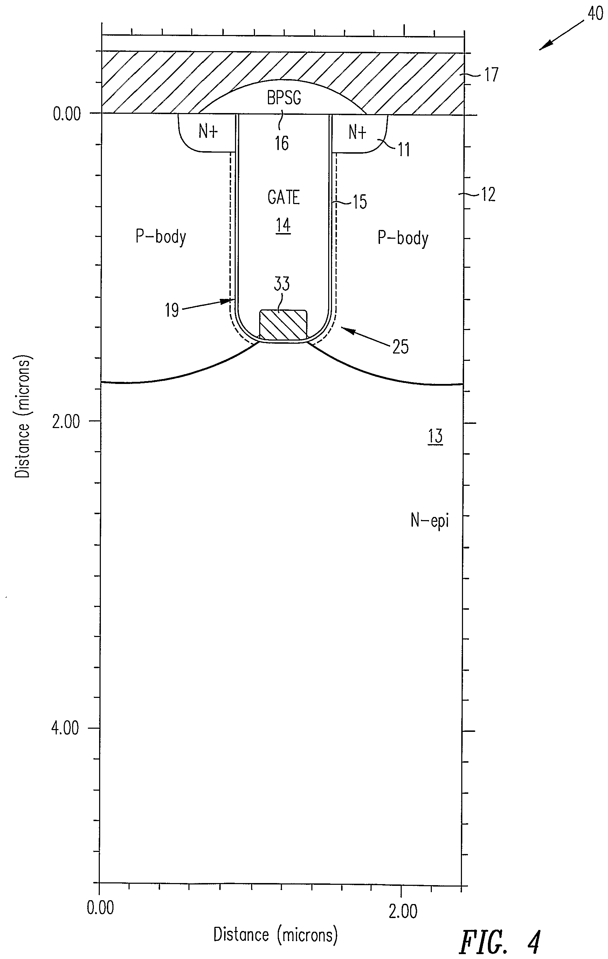

**Fig. 4** is a cross-sectional view of one embodiment of a trench MOSFET 40 in accordance with the present invention. In MOSFET 40, an n-type epitaxial ("N-epi") layer 13, which may be an N⁻ layer and is usually grown on an N⁺ substrate (not shown), is the drain. A p-type body region 12 separates N-epi layer 13 from N⁺ source regions 11. Body region 12 is diffused along the sidewall of a trench 19, past a corner region 25, and partially long the bottom of trench 19. Current flows vertically through a channel (denoted by the dashed lines) along the sidewall and around corner region 25 of trench 19.

The sidewall and corner region 25 of trench 19 are lined with a thin gate insulator 15 (e.g., silicon dioxide). An oxide plug 33 is centrally located in the bottom of trench 19. Trench 19 is filled with a conductive material, such as doped polysilicon, which forms a gate 14. Gate 14 extends into corner region 25 of trench 19, between oxide plug 33 and gate insulator 15. Trench 19, including gate 14 and oxide plug 33 therein, is covered with an insulating layer 16, which may be borophosphosilicate glass (BPSG). Electrical contact to source regions 11 and body region 12 is made with a conductor 17, which is typically a metal or metal alloy. Gate 14 is contacted in the third dimension, outside of the plane of **Fig. 4****.**

The trench MOSFET of **Fig. 4** uses oxide plug 33 to separate gate 14 from N-epi layer 13, thereby decreasing the gate-to-drain capacitance, C_{gd}. Having the channel extend around corner region 25 to the bottom of the trench precludes significant gate-to-drain overlap in thin gate oxide regions (i.e., see thin gate oxide regions 24 in **Fig. 3**) because the diffusion of body region 12 can be very well controlled through corner region 25. Since lateral diffusion is six to ten times slower than vertical diffusion, the pn junction between body region 12 and N-epi layer 13 can be made to coincide with the transition between thin gate insulator 15 and oxide plug 33. Thus, oxide plug 33 and active corner region 25 minimize the gate-to-drain capacitance, C_{gd}, with minimum impact on on-resistance, Rₒₙ, yielding a trench MOSFET 40 useful for high frequency applications.

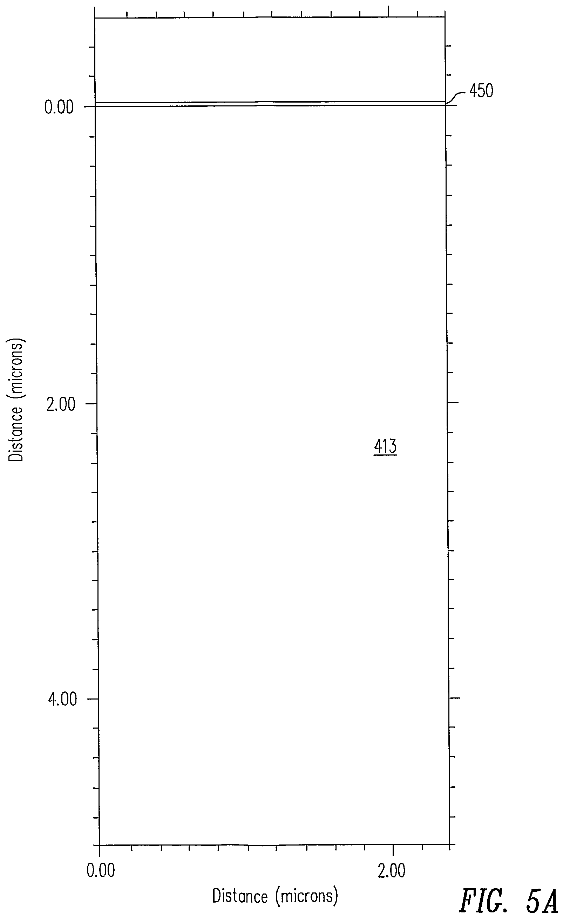

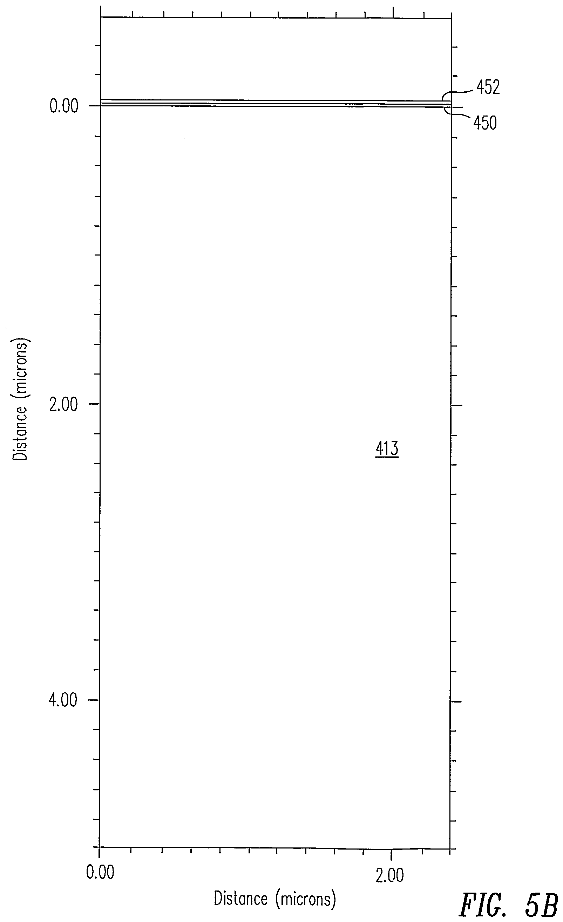

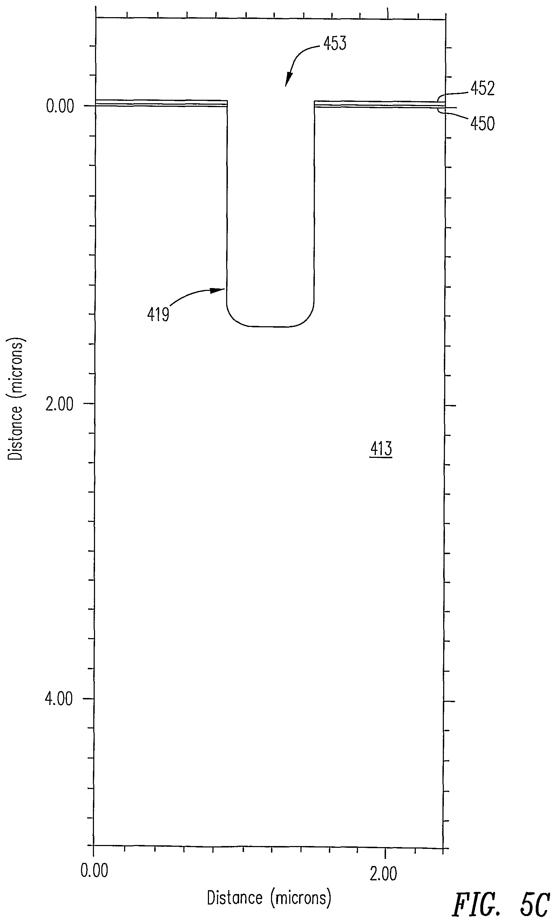

**Figs. 5A-5P** are cross-sectional views illustrating one embodiment of a process for fabricating a trench MOSFET, such as MOSFET 40 of **Fig. 4****,** in accordance with the present invention. As shown in **Fig. 5A****,** the process begins with a lightly-doped N-epi layer 413 (typically about 8 µm thick) grown on a heavily doped N⁺ substrate (not shown). A pad oxide 450 (e.g., 10-20 nm (100-200 Å)) is thermally grown by dry oxidation at 950 °C for 10 minutes on N-epi layer 413. As shown in **Fig. 5B****,** a nitride layer 452 (e.g., 20-30nm (200-300 Å)) is deposited by chemical vapor deposition (CVD) on pad oxide 450. As shown in **Fig. 5C****,** nitride layer 452 and pad oxide 450 are patterned to form an opening 453 where a trench 419 is to be located. Trench 419 is etched through opening 453, typically using a dry plasma etch, for example, a reactive ion etch (RIE). Trench 419 may be about 0.5-1.2 µm wide and about 1-2 µm deep.

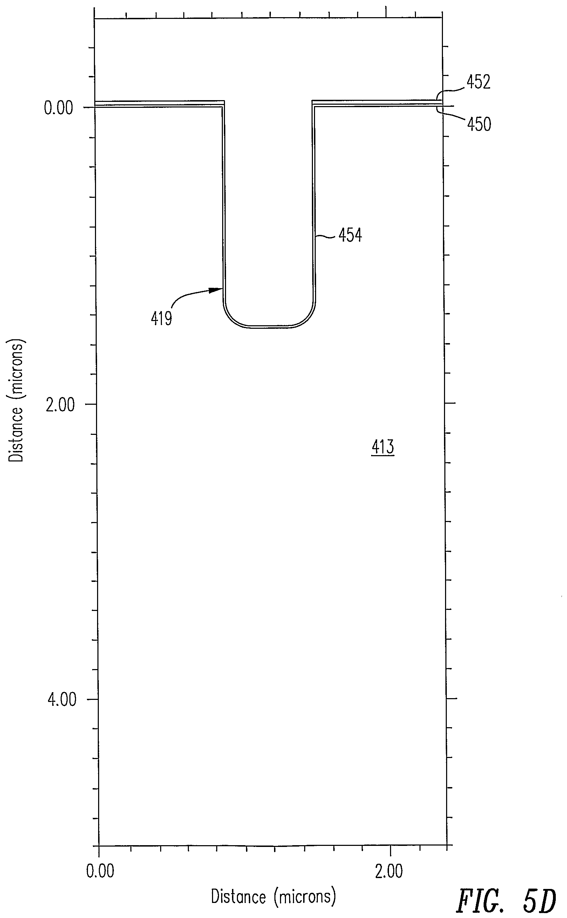

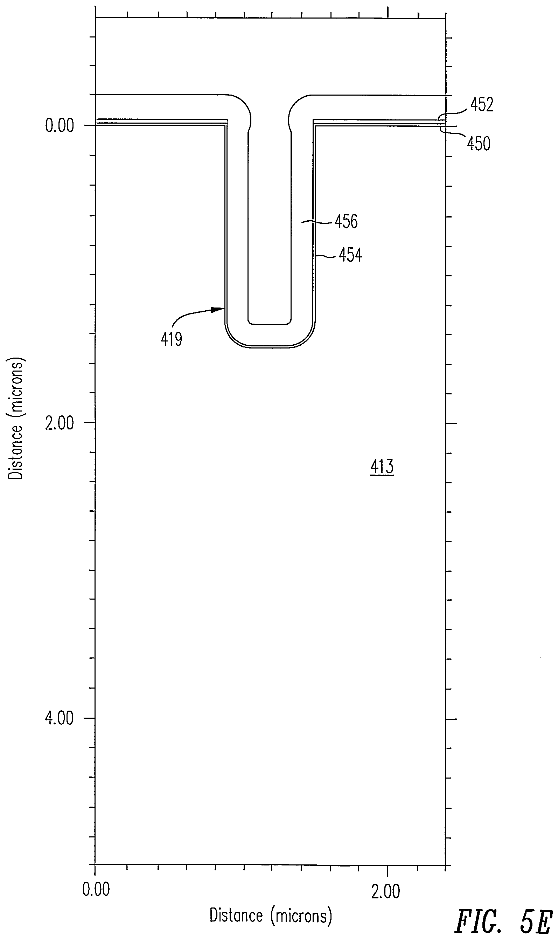

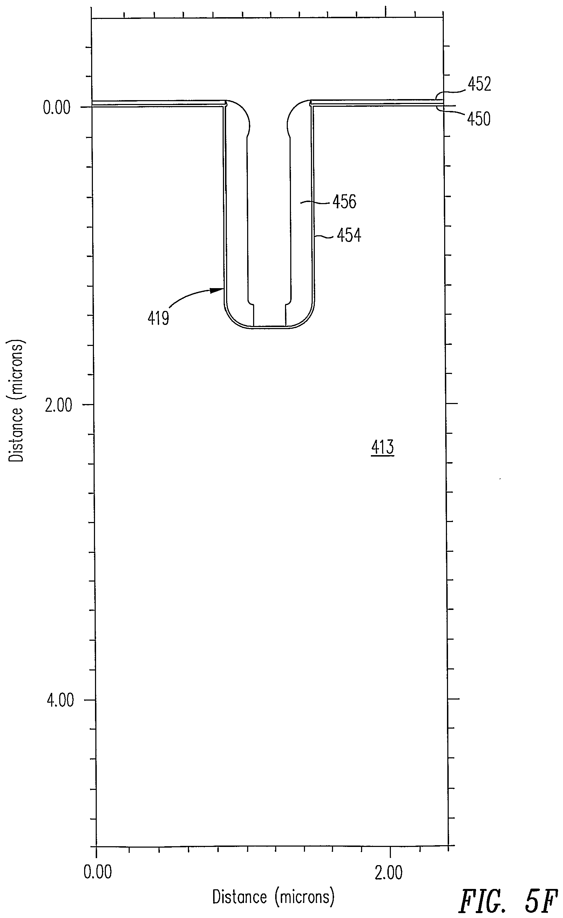

A second pad oxide 454 (e.g., 10-20 nm (100-200 Å)) is thermally grown on the sidewall and bottom of trench 419, as shown in **Fig. 5D**. A thick nitride layer 456 (e.g., 100-200 nm (1000-2000 Å)) is deposited conformally by CVD on the sidewall and bottom of trench 419 as well as on top of nitride layer 452, as shown in **Fig. 5E****.** Nitride layer 456 is etched using a directional, dry plasma etch, such as an RIE, using etchants that have high selectivity for nitride layer 456 over pad oxide 450. The nitride etch leaves spacers of nitride layer 456 along the sidewall of trench 419, while exposing pad oxide 454 in the central bottom portion of trench 419, as shown in **Fig. 5F****.** It is possible that nitride layer 456 may be overetched to such a degree that nitride layer 452 is removed from the top of pad oxide 450.

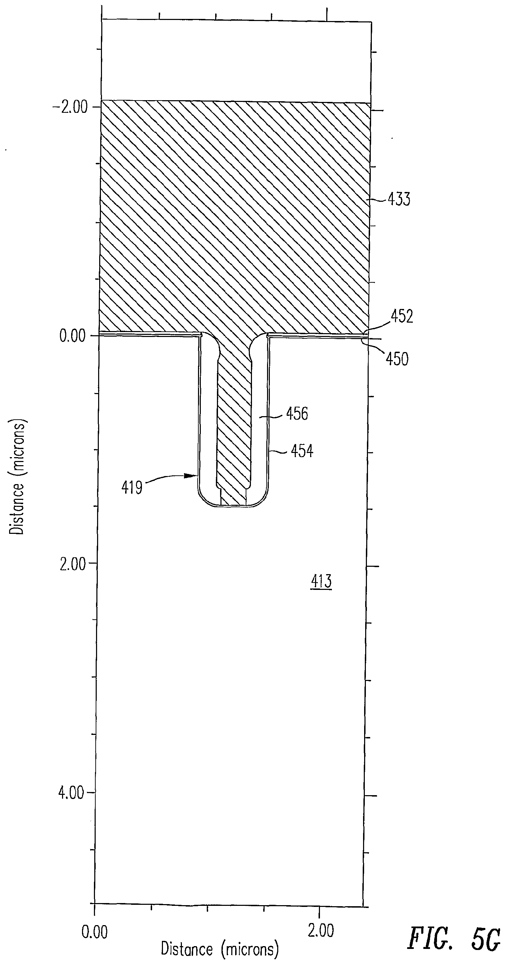

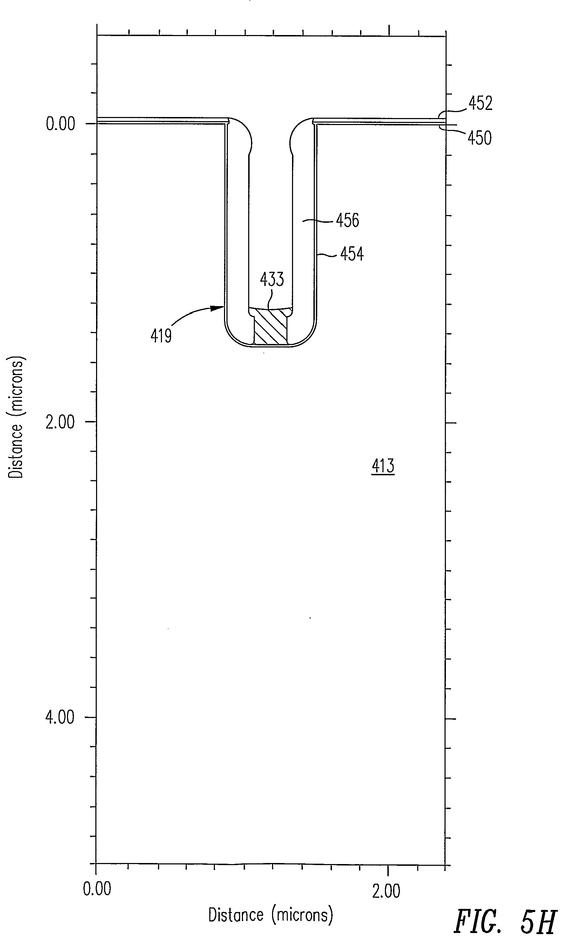

As shown in **Fig. 5G****,** a thick insulating layer 433 (e.g., 2-4 µm) is then deposited. The deposition process is chosen, according to conventional deposition techniques such as CVD, to be non-conformal, filling trench 419 and overflowing onto the top surface of N-epi layer 413. Thick insulating layer 433 may be, for example, a low temperature oxide (LTO), a phosphosilicate glass (PSG), a BPSG, or another insulating material. Insulating layer 433 is etched back, typically by performing a wet etch, using an etchant that has high selectivity for insulating layer 433 over nitride layer 456. Insulating layer 433 is etched back into trench 419 until only about 0.1-0.2 µm remains in trench 419, as shown in **Fig. 5H****.**

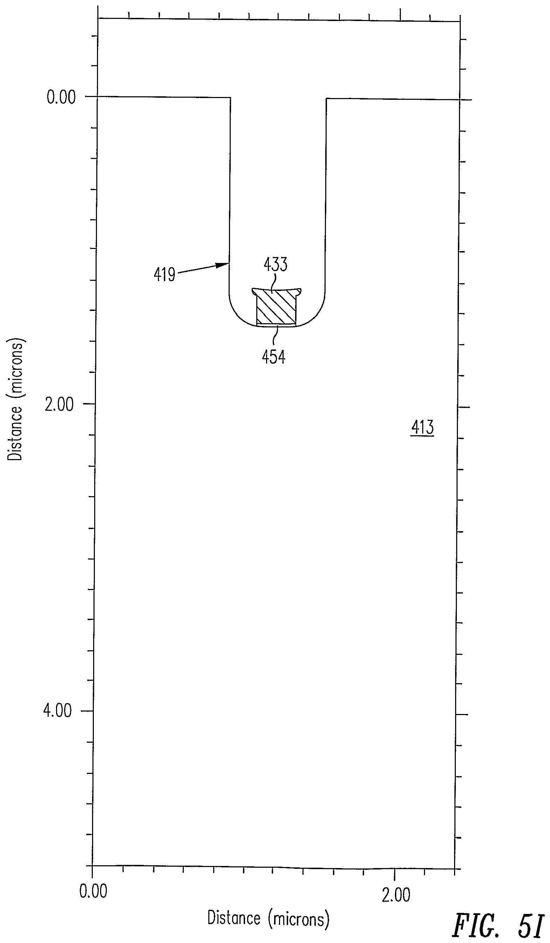

Nitride layer 456 is removed, typically by performing a wet etch, using an etchant that has high selectivity for nitride layer 456 over insulating layer 433. Pad oxide 450 is also removed, typically by a wet etch. This wet etch will remove a small, but insignificant portion of insulating layer 433, leaving the structure as shown in **Fig. 5I****.**

In some embodiments, an approximately 50 nm (500 Å) sacrificial gate oxide (not shown) can be thermally grown by dry oxidation at 1050 °C for 20 minutes and removed by a wet etch to clean the sidewall of trench 419. The wet etch of such a sacrificial gate oxide is kept short to minimize etching of insulative layer 433.

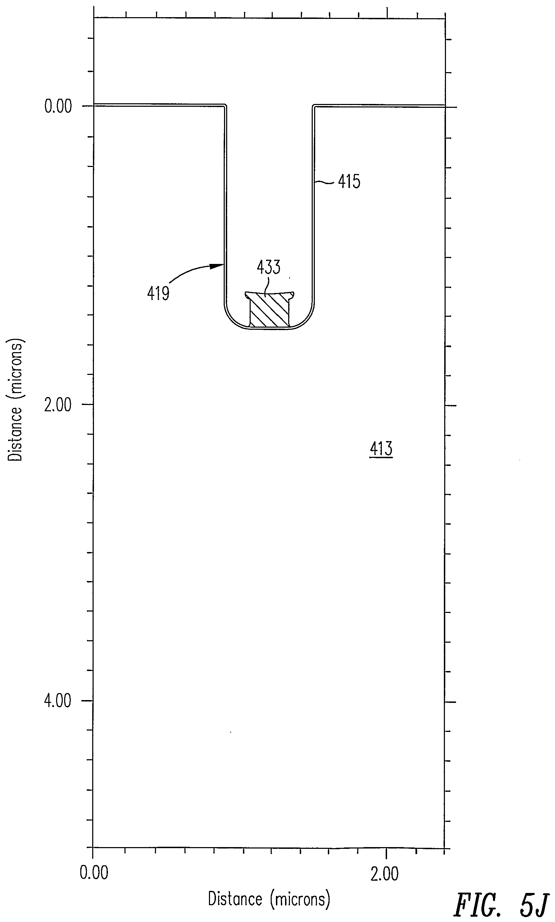

As shown in **Fig. 5J****,** a thin gate insulator 415 (e.g., about 30-100 nm (300-1000 Å) thick) is then formed on the sidewall of trench 419 and the top surface of N-epi layer 413. Thin gate insulator 415 may be, for example, a silicon dioxide layer that is thermally grown using a dry oxidation at 1050 °C for 20 minutes.

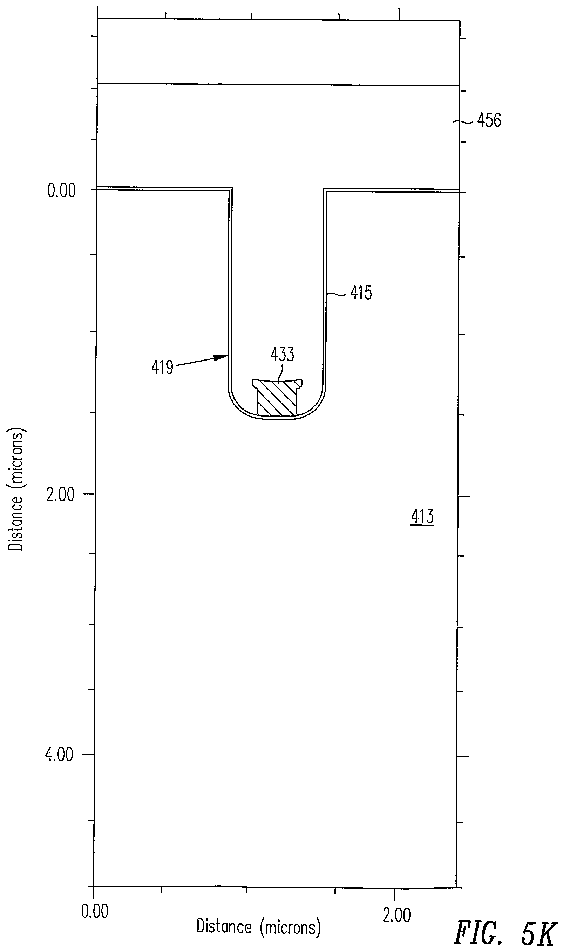

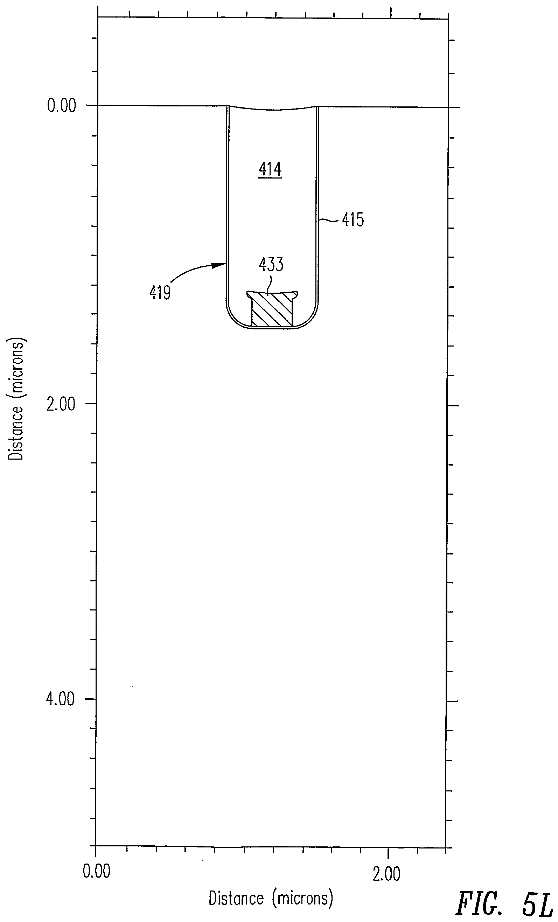

As shown in **Fig. 5K****,** a conductive material 456 is deposited by CVD, possibly by low pressure CVD (LPCVD), to fill trench 419 and overflow past the topmost surface of thin gate insulator 415. Conductive material 456 may be, for example, an in-situ doped polysilicon, or an undoped polysilicon layer that is subsequently implanted and annealed, or an alternative conductive material. Conductive material 456 is etched, typically using a reactive ion etch, until the top surface of material 456 is approximately level with the top of N-epi layer 413, thereby forming gate 414, as shown in **Fig. 5L****.** In an n-type MOSFET, gate 414 may be, for example, a polysilicon layer with a doping concentration of 10²⁰ cm⁻³. In some embodiments, conductive material 456 may be etched past the top of trench 419, thereby recessing gate 414 to minimize the gate-to-source overlap capacitance.

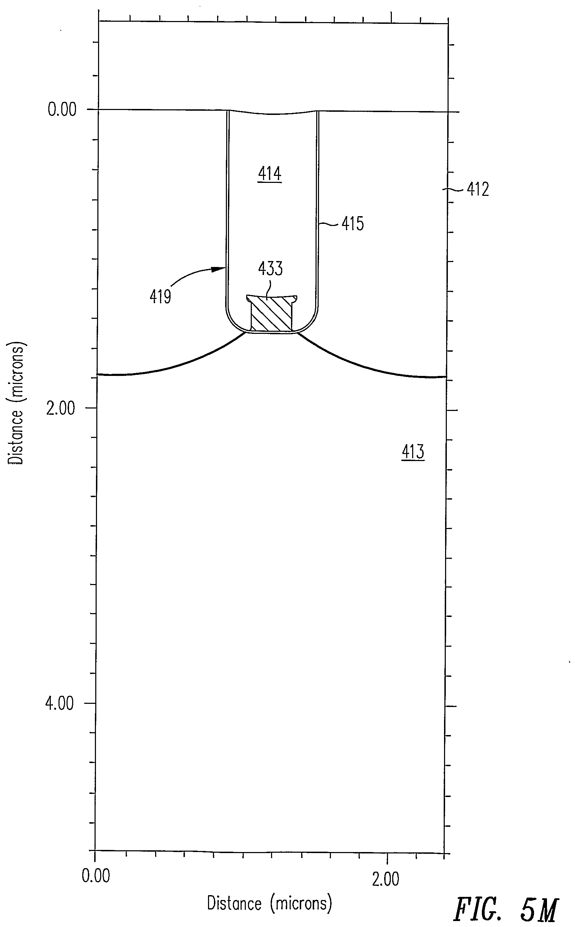

Using known implantation and diffusion processes, P-type body regions 412 are formed in N-epi layer 413 as shown in **Fig. 5M****.** Body regions 412 are diffused such that the PN junctions between p-type body regions 412 and the remainder of N-epi layer 413 are located near the interface between thick insulating layer 433 and thin gate insulator 415. This interface occurs at a location along the bottom of trench 419, where the diffusion of body regions 412 is dominated by lateral diffusion under trench 419 rather than vertical diffusion deeper into N-epi layer 413, making control of the diffusion of body regions 412 easier.

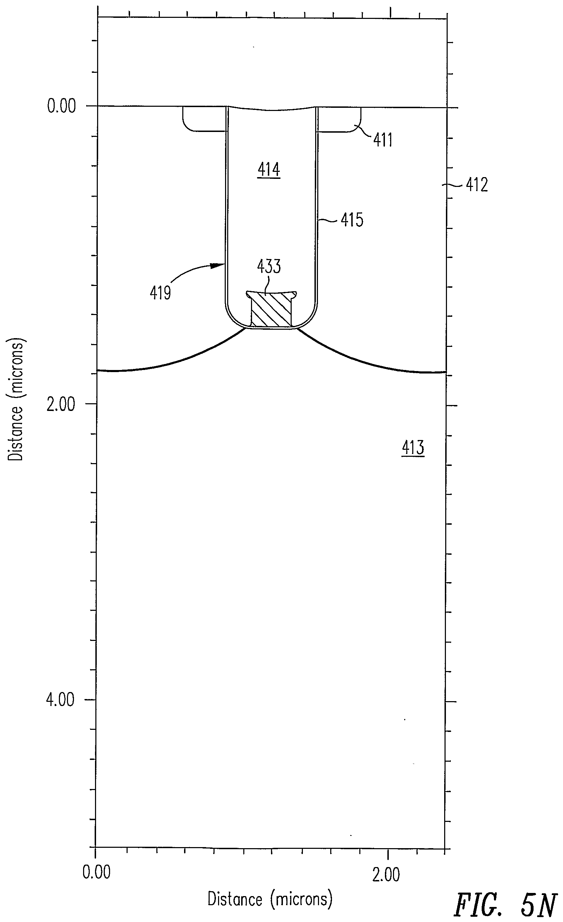

Using known implantation and diffusion processes, N⁺ source regions 411 are formed in N-epi layer 413 as shown in **Fig. 5N****.**

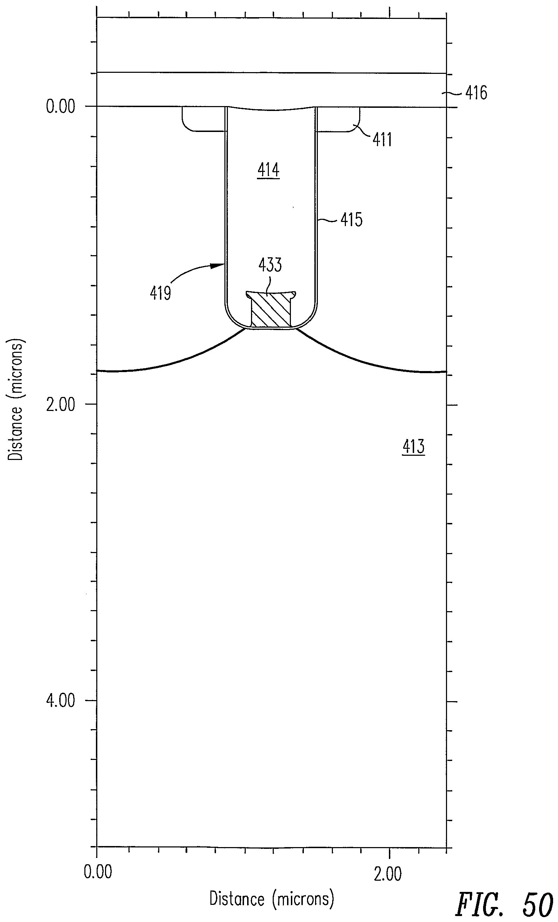

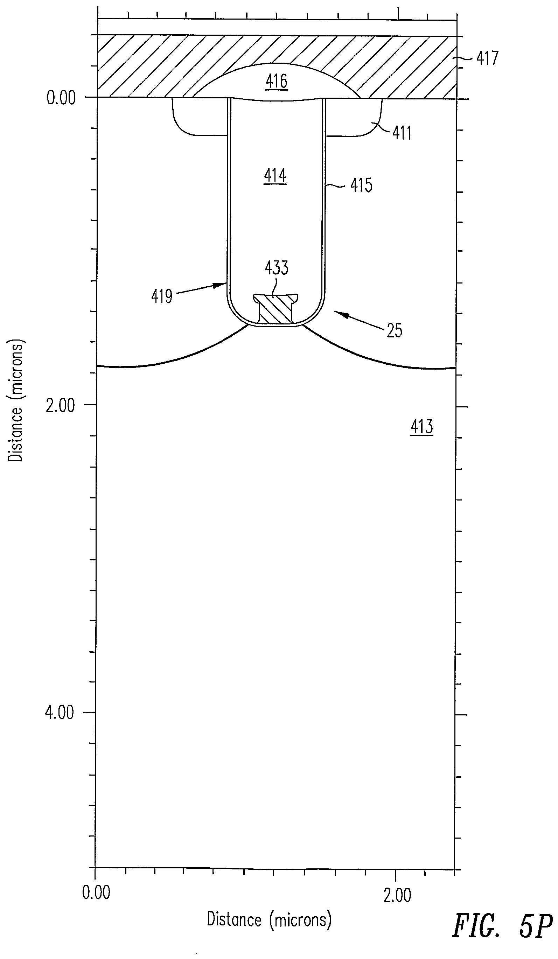

As shown in **Fig. 5O****,** an insulating layer 416, which may be borophosphosilicate glass (BPSG), is deposited by CVD on the surfaces of N-epi layer 413 and gate 414. Insulating layer 416 is etched, typically using a dry etch, to expose portions of p-type body regions 412 and N⁺ source regions 411, as shown in **Fig. 5P****.** Electrical contact to body regions 412 and source regions 411 is made with a conductor 417, which is typically a deposited (e.g., by physical vapor deposition) metal or metal alloy. Electrical contact to gate 414 is made in the third dimension, outside of the plane of **Fig. 5P****.** Electrical contact to the drain (not shown) is made to the opposite surface of the N⁺ substrate (not shown) on which N-epi layer 413 is grown.

This method thus allows incorporation of thick insulating layer 433, centrally positioned at the bottom of trench 419, to decrease C_{gd} with minimal undesirable effects or manufacturing concerns. For example, stress effects from growing a thick oxide in the concave bottom of trench 419 are avoided by depositing the oxide rather than thermally growing it. In addition, by keeping corner region 25 active (i.e., part of the MOSFET channel), the gate-to-drain overlap in thin gate oxide regions 24 of MOSFET 30 (see **Fig. 3**) are avoided. This minimizes C_{gd}.

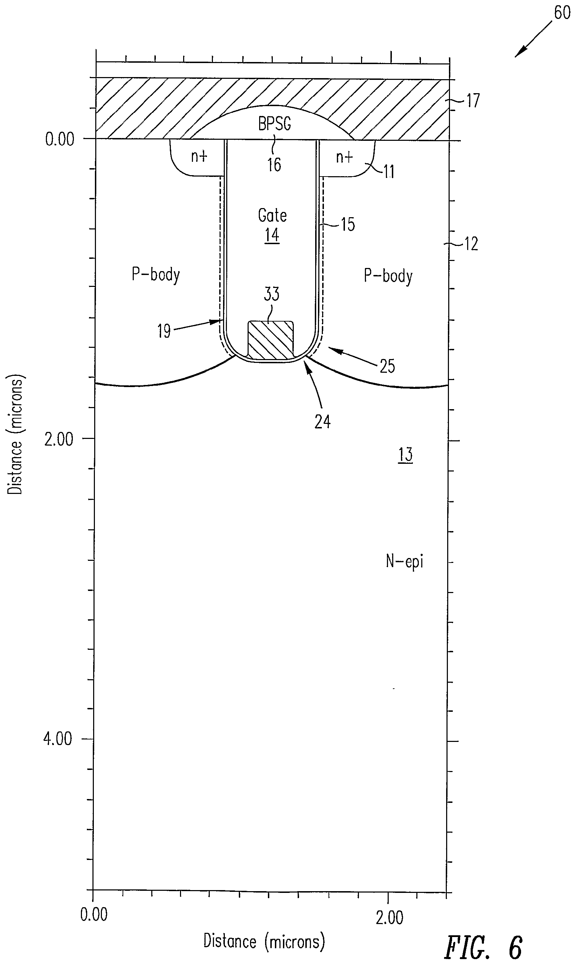

**Fig. 6** is a cross-sectional view of an alternative embodiment of a trench MOSFET 60 in accordance with the present invention. MOSFET 60 has many similarities to MOSFET 40 of **Fig. 4****.** In particular, the sidewall and corner region 25 of trench 19 are lined with thin gate insulator 15, while oxide plug 33 is centrally located in the bottom of trench 19. In **Fig. 6****,** however, the PN junctions between body regions 12 and N-epi layer 13 are not located as near to the interface between oxide plug 33 and thin gate insulator 15 as in MOSFET 40 of **Fig. 4****.** In fact, the location of the PN junctions between body regions 12 and N-epi layer 13 can vary. As discussed above with reference to **Fig. 5M****,** body regions 412 are formed using known implantation and diffusion techniques. The structure of MOSFET 60 of **Fig. 6** can be fabricated by varying the diffusion conditions associated with the diffusion of body regions 12 so that diffusion stops before body regions 12 reach the interface of oxide plug 33.

MOSFET 60 of **Fig. 6** exhibits reduced gate-to-drain capacitance, C_{gd}, compared to MOSFET 10 of **Fig. 1****,** MOSFET 20 of **Fig. 2****,** and MOSFET 30 of **Fig. 3****.** MOSFET 10 of **Fig. 1** has a large C_{gd} due to thin gate insulator 15 throughout overlap region 18. MOSFET 20 of **Fig. 2** and MOSFET 30 of **Fig. 3** have large C_{gd} due to thin gate insulator 15 throughout thin gate oxide regions 24, since regions 24 may be large due to the fast nature of vertical diffusion. The extent of thin gate oxide region 24 in MOSFET 60 of **Fig. 6****,** however, can be minimized since the diffusion of body regions 12 in thin gate oxide region 24 will be dominated by lateral diffusion under trench 19, instead of vertical diffusion deeper into N-epi layer 13.

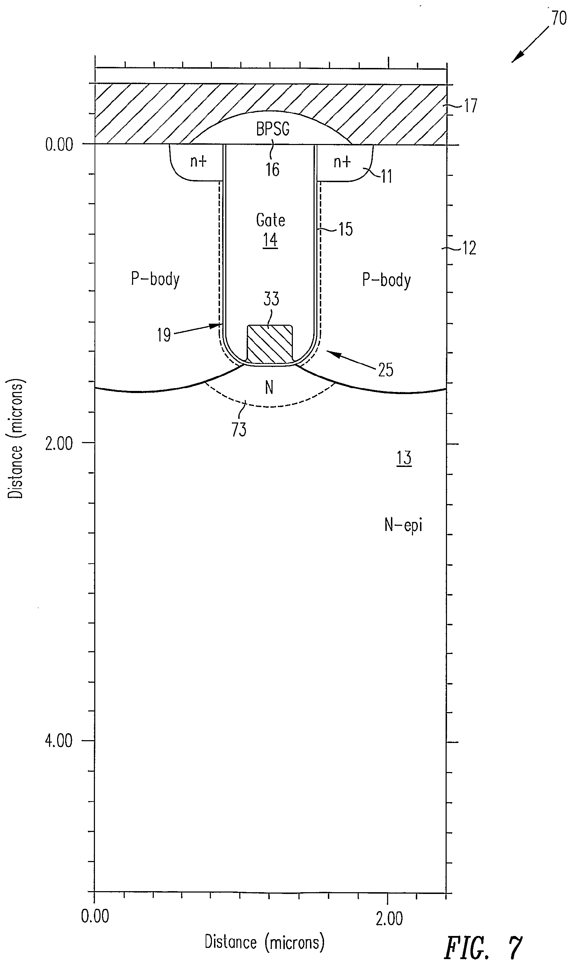

**Fig. 7** is a cross-sectional view of an alternative embodiment of a trench MOSFET 70 in accordance with the present invention. MOSFET 70 has many similarities to MOSFET 40 of **Fig. 4****.** In particular, the sidewall and corner region 25 of trench 19 are lined with thin gate insulator 15, while oxide plug 33 is centrally located in the bottom of trench 19. In MOSFET 40 of **Fig. 4****,** oxide plug 33 may increase the on-resistance (Rₒₙ) of MOSFET 40 due to an increase in the spreading resistance in the accumulation layer at the bottom of trench 19. MOSFET 70 of **Fig. 7****,** however, includes a high doping region 73 at the bottom of trench 19 to help spread current more effectively and minimize pinching of body region 12. High doping region 73 also helps self-align the PN junction between p-type body regions 412 and N-epi layer 413 to the edge of thick insulating layer 433, during the diffusion process shown in **Fig. 5M****.** Highly doped region 73 is formed in N-epi layer 13. Highly doped region 73 may be created by implanting an n-type dopant, such as arsenic or phosphorous, after trench 19 is etched as shown in **Fig. 5C****,** after pad oxide 454 is formed as shown in **Fig. 5D****,** or after nitride layer 456 is etched as shown in **Fig. 5F****.** Thus, oxide plug 33 minimizes gate-to-drain capacitance, C_{gd}, and highly doped region 73 minimizes on-resistance, Rₒₙ, yielding a trench MOSFET 70 well-suited for high frequency applications.

As mentioned above, positioning the transition between the thick and thin sections of the gate oxide layer at the bottom of the trench is advantageous in aligning the transition with the junction between the body region and the N-epi region because the body region diffuses more slowly in a lateral direction than in a vertical direction. In another variation according to this invention, this alignment is further improved by forming a gradual transition between the thick and thin sections of the gate oxide layer.

The process may be identical to that described above through the step illustrated in **Fig. 5F****,** where the nitride etch leaves spacers of nitride mask layer 456 along the sidewall of trench 419, while exposing pad oxide 454 in the central bottom portion of trench 419. In the next step, however, instead of depositing a thick insulating layer by, for example, CVD, a thick oxide layer is grown by a thermal process. When this is done, the thermal oxide consumes part of the silicon and thereby undercuts the edges of the nitride layer, causing the nitride layer to "lift off' of the surface of the trench. This forms a structure that is similar to the "bird's beak" in a conventional LOCOS (local oxidation of silicon) process that is often used to create field oxide regions on the top surface of a semiconductor device.

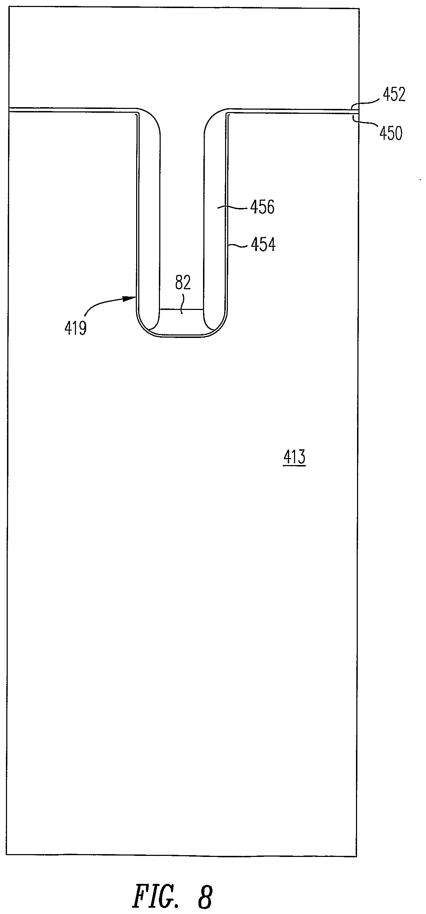

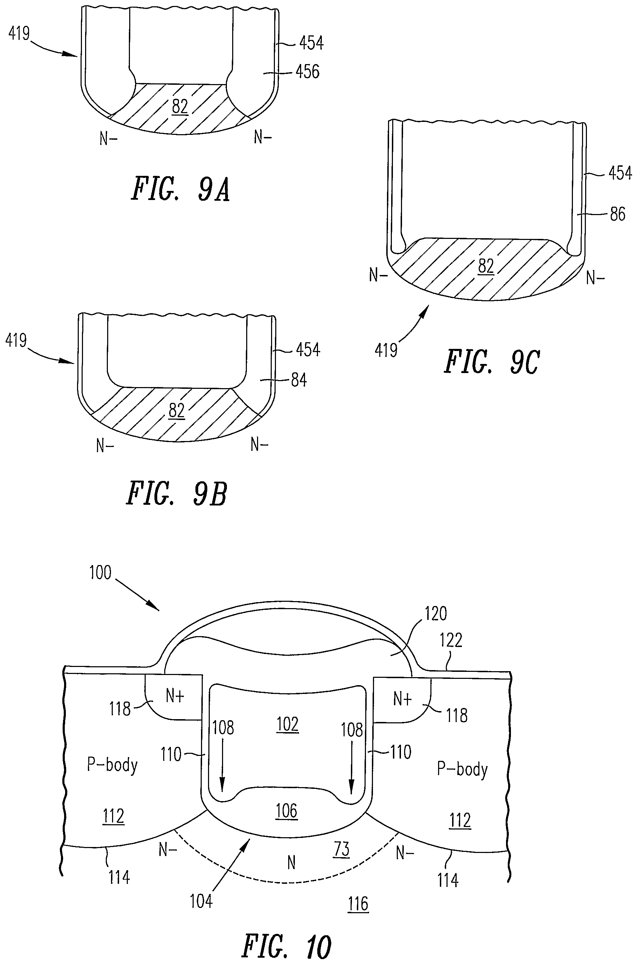

**Fig. 8** shows the structure after a thermal oxide layer 82 has been grown at the bottom of trench 419. The structure is shown in detail in **Fig. 9A**. The edges of thermal oxide layer 82 have pushed under nitride layer 456 and as a result become sloped or tapered.

Altering the thickness of the nitride layer allows one to position the edges of the oxide layer at different locations. **Fig. 9A** shows a relatively thick nitride layer 456, and as a result the edges of oxide layer 82 are located on the bottom of trench 419. **Fig. 9B** shows a thinner nitride layer 84, with the edges of oxide layer 82 located essentially at the corners of trench 419. **Fig. 9C** shows an even thinner nitride layer 86 with the edges of oxide layer 82 located on the sidewalls of trench 419.

In a similar manner, the edges of the oxide layer may be positioned at various intermediate points by altering the thickness of the nitride layer. The thickness of the nitride layer is independent of the width or depth of trench 419. For example, if the nitride layer is in the range of 150 to 200 nm (1500-2000 Å) thick, the edges of oxide layer 82 would most likely be located on the bottom of trench 419 **(****Fig. 9A****).** If the nitride layer is 50 nm (500 Å) or less thick, the edges of oxide layer 82 would typically be located on the sidewalls of trench 419 **(****Fig. 9C****).**

Oxide layer 82 may be grown, for example, by heating the silicon structure at a temperature from 1,000 °C to 1,200 °C for 20 minutes to one hour.

After the thermal oxide layer has been grown, the nitride layer may be removed by etching with a nitride etchant. To ensure that all of the nitride is removed, another anneal may be performed, for example, at 1,000 °C for 5-10 minutes to oxidize any remaining nitride, and the anneal may be followed by an oxide etch. The oxide etch removes any oxidized nitride but does not remove significant portions of oxide layer 82.

A gate oxide layer may then be grown, the trench may be filled with a gate material such as polysilicon, and the other steps described above and illustrated in **Figs. 5I-5P** may be performed. With reference to **Fig. 5M****,** the diffusion of P-type dopant is controlled such that the PN junction between P-body 412 and N-epi region 413 intersects the trench somewhere within the "bird's beak" area, where the thickness of the oxide layer is gradually decreasing. Thus the PN junction does not need to be located at a particular point.

**Fig. 10** illustrates a MOSFET 100 fabricated in accordance with this embodiment of the invention. MOSFET 100 includes a gate electrode 102 that is positioned in a trench 104, which is lined with an oxide layer. The upper surface of gate electrode 102 is recessed into trench 104. The oxide layer includes a thick section 106, formed in accordance with this invention, which is located generally at the bottom of trench 104, and relatively thin sections 110 adjacent the sidewalls of trench 104. Between thick section 106 and thin sections 110 are transition regions 108, where the thickness of the oxide layer decreases gradually from thick section 106 to thin sections 110. MOSFET 100 also includes P-body regions 112, which form PN junctions 114 with an N-epi region 116. PN junctions 114 intersect trench 104 in the transition regions 108. As described above, the location of transition regions 108 can be varied by altering the thickness of the nitride layer during the fabrication of MOSFET 100.

MOSFET 100 also includes N+ source regions 118, a thick oxide layer 120 overlying gate electrode 102, and a metal layer 122 that makes electrical contact with P-body regions 112 and N+ source regions 118. As shown by the dashed lines, MOSFET 100 may contain a highly doped region 73 at the bottom of trench 104. Highly doped region 73 may be created by implanting an n-type dopant, such as arsenic or phosphorous, after the trench has been formed as shown in **Fig. 5C****,** after the pad oxide has been formed as shown in **Fig. 5D****,** or after the nitride layer has been etched as shown in **Fig. 5F****.**

Fabricating a device in accordance with this embodiment allows a greater margin of error in the positioning of the PN junction between the P-body region and the N-epi. Compared with MOSFET 40 shown in **Fig. 4****,** for example, the body-drain junctions do not need to be precisely positioned at the sharp edges of oxide plug 33. In addition, the breakdown characteristics of the MOSFET are enhanced because the thickness of the oxide at the trench corners can be increased without increasing the thickness of the gate oxide near the channel region and thereby raising the threshold voltage.

The foregoing embodiments are intended to be illustrative and not limiting of the broad principles of this invention. Many additional embodiments will be apparent to persons skilled in the art. For example, the structures and methods of this invention can be used with any type of metal-insulator-semiconductor (MIS) device in which it is desirable to form an insulating layer between a trench gate and a region outside the trench, while minimizing the gate-to-drain overlap regions. Also, various insulating or conductive materials can be used where appropriate, and the invention is also applicable to p-type MOSFETs. The invention is limited only by the following claims.

## Claims

1. A metal-insulator-semiconductor device, comprising:
a semiconductor substrate (13) including a trench (19) extending into the substrate (13) from a surface of the substrate (13), the trench (19) having a sidewall and a bottom surface comprising a corner surface and a central bottom surface; a source region (11) of a first conductivity type abutting the sidewall of the trench (19) and the surface of the substrate (13);
a body region (12) of a second conductivity type opposite to the first conductivity type abutting the source region (11); and
a drain region (N-epi) of the first conductivity type abutting the body region (12) and the central bottom surface of the bottom surface of the trench (19),
wherein the trench (19) is lined with a first insulating layer (15) that abuts the sidewall and the corner surface and with a second insulative layer (33) that abuts the central bottom surface of the trench, the second insulating layer (33) being thicker than the first insulating layer (15);
**characterized in that**
the body region (12) abuts both the sidewall and the corner surface of the bottom surface of the trench (19).

2. The device of Claim 1, further comprising a gate region (14) coupled to the first insulating layer (15) and the second insulating layer (33) within the trench (19).

3. The device of Claim 1, further including a high conductivity region (73) of the first conductivity type formed in the drain region (N-epi) abutting the central bottom surface of the bottom surface of the trench (19).

4. The device of Claim 1, wherein the first insulative layer (15) extends to the interface between the corner surface of the bottom surface and the central bottom surface of the bottom surface of the trench (19)..

5. The device of Claim 4, wherein the body region (12) extends to the interface between the corner surface of the bottom surface and the central bottom surface of the bottom surface of the trench (19).

6. The device of Claim 4, wherein the body region (12) extends to a first distance along the corner surface of the bottom surface of the trench (19).

7. The device of Claim 1, wherein the first insulative layer (15) comprises an oxide insulating layer.

8. The device of Claim 1, wherein the second insulative layer (33) comprises an oxide or a multilayer insulating
layer.

9. A semiconductor device comprising a semiconductor substrate including a trench (104) extending into the substrate from a surface of the substrate, the trench (104) having a sidewall and a bottom surface comprising a corner surface and a central bottom surface; a source region (118) of a first conductivity type abutting the sidewall of the trench (104) and the surface of the substrate; a body region (112) of a second conductivity type opposite to the first conductivity type abutting the source region (118); and a drain region (N-epi) of the first conductivity type abutting the body region (112) and the central bottom surface of the trench (104), wherein the trench (104) is lined with an oxide layer comprising a first section (106) abutting the central bottom surface of the bottom surface of the trench, a second section (110) abutting the sidewall of the trench and a transition region (108) between the first and second sections (106,110), the first section (106) abutting at least a portion of the drain region, the second section (110) abutting at least a portion of the body region (112), a thickness of the oxide layer in the first section (106) being greater than a thickness of the oxide layer in the second section (110), the thickness of the oxide layer in the transition region (108) decreasing gradually from the first section (106) to said second section (110),
**characterized by** a PN junction (114) between the drain region (N N-) and the body region (112) terminating at the trench (104) abutting the transition region (108) of the oxide layer (106, 108, 110) at the corner surface of the bottom surface of the trench.

10. The device of Claim 9, comprising a highly doped region (73) of the first conductivity type abutting the central bottom surface of the bottom of the trench (104), the highly doped region (73) having a doping concentration greater than a doping concentration of a portion of the drain (N-) outside the highly-doped region (73).

11. A method of fabricating an MIS device comprising:
providing a semiconductor substrate (413) of a first conductivity type;
forming a trench (419) in the substrate (413), the trench (413) including a sidewall and a bottom surface comprising a corner surface and a central bottom surface;
depositing a thick insulating
layer (433) on the central bottom surface; forming a thin insulating layer (415) on the sidewall and on the corner surface;
forming a gate (414) in the trench (419);
forming a source region (411) of a first conductivity type, and
diffusing a dopant (412) of a second conductivity type into the substrate (413) along the sidewall;
**characterized by**
continuing to diffuse the dopant (412) laterally along the corner surface of the bottom surface of the trench so as to form an active corner region of the trench (419).

12. The method of Claim 11, wherein the depositing of the thick insulting
layer (433) comprises:
depositing a mask layer (456) on the sidewall, the corner surface, and the central bottom surface;
etching the mask layer (456) to expose the central bottom surface of the trench (419);
depositing a thick insulating layer (433) in the trench (419); etching the thick insulating layer (433) to form an exposed portion of the mask layer (456) on the sidewall while leaving a portion of the thick insulating layer (433) on the central bottom surface of the trench (419); and removing the mask layer (456) to expose the sidewall and the corner surface of the trench (419) while leaving the portion of the thick insulating layer (433) on the central bottom surface of the trench (419).

13. The method of Claim 12, wherein the mask layer (456) comprises a nitride layer and wherein forming the thick insulating layer (433) comprises growing an oxide layer (433) by a thermal process.

14. The method of Claim 12, wherein the thin insulating layer (415) comprises a gate oxide layer.

15. The method of Claim 12, wherein forming a gate (414) comprises depositing doped polysilicon in the trench (419) and etching the doped polysilicon to a level about equal to a surface of the substrate (413).

16. The method of Claim 11, wherein following the diffusion the dopant (412) forms a PN junction with a remaining portion of the substrate (413), the PN junction being located near an interface between the thick insulating layer (433) and the thin insulting layer (415).

17. The method of Claim 12, comprising implanting dopant through a bottom of the trench (19) to form a heavily doped region (73) adjacent the bottom of the trench (19).

18. A method of fabricating an MIS device comprising:
providing a semiconductor substrate of a first conductivity type;
forming a trench (104) in said substrate, the trench including a sidewall and a bottom surface comprising a corner surface and a central bottom surface;
depositing a nitride layer in said trench (104);
etching said nitride layer to form an exposed area at the central bottom surface of said trench (104);
and heating the substrate and thereby growing an oxide layer in said exposed area, removing said nitride layer;
forming a relatively thin gate oxide layer on at least a portion of the sidewall of said trench (104);
forming a gate (102) in said trench (104), and
forming a source region (118) of a first conductivity type,
wherein growing an oxide layer comprises creating a transition region (108) wherein a thickness of the oxide layer gradually decreases in a direction away form said exposed area, the method further comprising diffusing dopant of a second conductivity type into said substrate, said dopant forming a PN junction (114) with a remaining portion of said substrate, **characterized in that** diffusing dopant of said second conductivity type comprises controlling the diffusion of said PN junction (114) such that said PN junction (114) intersects the trench in said transition region (108) at the corner surface of the bottom surface of the trench.

## Patentansprüche

1. Metall-Isolator-Halbleiterbauteil umfassend:
ein Halbleitersubstrat (13), das einen Graben (19) umfasst, der sich in dem Substrat (13) von einer Oberfläche des Substrats (13) erstreckt, wobei der Graben (19) eine Seitenwand und eine Bodenoberfläche aufweist, die eine Eckenfläche und eine zentrale Bodenfläche hat;
einen Source-Bereich (11) von einem ersten Leitfähigkeitstyp, der an der Seitenwand des Grabens (19) und an der Oberfläche des Substrats (13) anstößt;
einen Körper-Bereich (12) von einem zweiten Leitfähigkeitstyp entgegengesetzt zu dem ersten Leitfähigkeitstyp, der an den Source-Bereich (11) anstößt; und
einen Drain-Bereich (N-epi) von dem ersten Leitfähigkeitstyp, der an den Körper-Bereich (12) und die zentrale Bodenfläche der Bodenoberfläche des Grabens (19) anstößt,
wobei der Graben (19) mit einer ersten Isolierschicht (15) ausgekleidet ist, die an der Seitenwand und der Eckenfläche ansteht, und mit einer zweiten Isolierschicht (33), die an der zentralen Bodenfläche des Grabens ansteht, wobei die zweite Isolierschicht (33) dicker als die erste Isolierschicht (15) ist;
**dadurch gekennzeichnet, dass**
der Körper-Bereich (12) sowohl an der Seitenwand als auch an der Eckenfläche der Bodenoberfläche des Grabens (19) anstößt.

2. Das Bauteil nach Anspruch 1, ferner umfassend einen Gate-Bereich (14), der mit der ersten Isolierschicht (15) und der zweiten Isolierschicht (33) in dem Graben (19) gekoppelt ist.

3. Das Bauteil nach Anspruch 1, ferner umfassend einen Hochleitfähigkeitsbereich (73) von dem ersten Leitfähigkeitstyp, der in dem Drain-Bereich (N-epi) ausgebildet ist, der an der zentralen Bodenfläche der Bodenoberfläche des Grabens (19) anstößt.

4. Das Bauteil nach Anspruch 1, worin die erste Isolierschicht (15) sich zu der Grenzfläche zwischen der Kantenoberfläche der Bodenoberfläche und der zentralen Bodenfläche der Bodenoberfläche des Grabens (19) erstreckt.

5. Das Bauteil nach Anspruch 4, worin der Körper-Bereich (12) sich zu der Grenzfläche zwischen der Eckenfläche der Bodenoberfläche und der zentralen Bodenfläche der Bodenoberfläche des Grabens (19) erstreckt.

6. Das Bauteil nach Anspruch 4, worin der Körper-Bereich (12) sich über ein der ersten Distanz entlang der Eckenfläche der Bodenoberfläche des Grabens (19) erstreckt.

7. Das Bauteil nach Anspruch 1, worin die erste Isolierschicht (15) eine Oxid-Isolierschicht aufweist.

8. Das Bauteil nach Anspruch 1, worin die zweite Isolierschicht (33) ein Oxid oder eine vielschichtige Isolierschicht aufweist.

9. Ein Halbleiter Bauteil umfassend:
ein Halbleitersubstrat, das einen Graben (104) umfasst, der sich in das Substrat von einer Oberfläche des Substrats erstreckt, wobei der Graben (104) eine Seitenwand und eine Bodenoberfläche mit einer Eckenfläche und einer zentralen Bodenfläche umfasst;
einen Source-Bereich (118) von dem ersten Leitfähigkeitstyp, der an der Seitenwand des Grabens (104) und der Oberfläche des Substrats anstößt;
ein Körper-Bereich (112) von einem zweiten Leitfähigkeitstyp entgegengesetzt zu dem ersten Leitfähigkeitstyp, der an den Source-Bereich (118) anstößt; und
einen Drain-Bereich (N-epi) von dem ersten Leitfähigkeitstyp, der an dem Körper-Bereich (112) und an der zentralen Bodenfläche des Grabens (104) anstößt,
wobei der Graben (104) mit einer Oxidschicht ausgekleidet ist, die einen ersten Abschnitt (106), der an der zentralen Bodenfläche der Bodenoberfläche des Grabens anstößt, einen zweiten Abschnitt (110), der an der Seitenwand des Grabens anstößt, und einen Übergangsbereich (108) zwischen dem ersten und dem zweiten Abschnitt (106,110) aufweist,
wobei der erste Abschnitt (106) an wenigstens einen Teil des Drain-Bereichs anstößt, wobei der zweite Abschnitt (110) wenigstens an einen Teil des Körper-Bereichs (112) anstößt, wobei die Dicke der Oxidschicht in dem ersten Abschnitt (106) größer ist als eine Dicke der Oxidschicht in dem zweiten Abschnitt (110), wobei die Dicke der Oxidschicht in dem Übergangsbereich (108) allmählich von dem ersten Abschnitt (106) zu dem zweiten Abschnitt (110) hin abnimmt,
**gekennzeichnet durch**
einen PN- Übergang (114) zwischen dem Drain-Bereich (N N-) und dem Körper-Bereich (112), der an dem Graben (104) endet, der an dem Übergangsbereich (108) der Oxidschicht (106,108,110) an der Eckenfläche der Bodenoberfläche des Grabens anstößt.

10. Das Bauteil nach Anspruch 9, umfassend einen hoch dotierten Bereich (73) von dem ersten Leitfähigkeitstyp, der an der zentralen Bodenfläche des Bodens des Grabens (104) anstößt, wobei der hoch dotierte Bereich (73) eine Dotierungskonzentration hat, die größer ist als eine Dotierungskonzentration von einem Abschnitt des Drains (N-) außerhalb des hoch dotierten Bereichs (73).

11. Ein Verfahren zur Herstellung eines MIS-Bauteils umfassend:
Bereitstellen eines Halbleiter Substrats (413) von einem ersten Leitfähigkeitstyp;
Ausbilden eines Grabens (419) in dem Substrat (413), wobei der Graben (413) eine Seitenwand und eine Bodenoberfläche umfasst, die eine Eckenfläche und eine zentrale Bodenfläche umfasst;
Abscheiden einer dicken Isolationsschicht (433) auf der zentralen Bodenfläche;
Ausbilden einer dünnen Isolierschicht (415) auf der Seitenwand und auf der Eckenfläche;
Ausbilden eines Gates (414) in dem Graben (419);
Ausbilden eines Source-Bereichs (411) von einem ersten Leitfähigkeitstyp, und
Diffundieren eines Dotierungsmittels (412) von einem zweiten Leitfähigkeitstyp in das Substrat (413) entlang der Seitenwand;
**gekennzeichnet durch**
kontinuierlich Weiterdiffundieren des Dotierungsmittels (412) seitlich entlang der Eckenfläche der Bodenoberfläche des Grabens, um einen aktiven Kantenbereich des Grabens (419) zu bilden.

12. Das Verfahren nach Anspruch 11, worin das Abscheiden der dicken Isolierschicht (433) umfasst:
Abscheiden einer Maskenschicht (456) auf der Seitenwand, der Eckenfläche und der zentralen Bodenfläche;
Ätzen der Maskenschicht (456), um die zentrale Bodenfläche des Grabens (419) freizulegen;
Abschneiden einer dicken Isolierschicht (433) in dem Graben (419);
Ätzen der dicken Isolierschicht (433), um einen freigelegten Teil der Maskenschicht (456) auf der Seitenwand auszubilden, während ein Abschnitt der dicken Isolierschicht (433) auf der zentralen Bodenfläche des Grabens (419) übrig gelassen wird; und
Entfernen der Maskenschicht (456), um die Seitenwand und die Eckenfläche des Grabens (419) freizulegen, während ein Teil der dicken Isolierschicht (433) auf der zentralen Bodenfläche des Grabens (419) übrig gelassen wird.

13. Das Verfahren nach Anspruch 12, worin die Maskenschicht (456) eine Nitridschicht aufweist, und wobei das Ausbilden der dicken Isolierschicht (433) das Aufwachsen einer Oxidschicht (433) durch einen thermischen Prozess umfasst.

14. Das Verfahren nach Anspruch 12, worin die dünne Isolierschicht (415) eine Gateoxid-Schicht umfasst.

15. Das Verfahren nach Anspruch 12, worin das Ausbilden eines Gates (414) das Abschneiden von dotierten Polysilizium in dem Graben (419) und das Ätzen des dotierten Polysiliziums auf ein Niveau etwa gleich einer Oberfläche des Substrats (413) umfasst.

16. Das Verfahren nach Anspruch 11, worin nachfolgend auf die Diffusion das Dotierungsmittel (412) einen PN-Übergang mit einem rechtlichen Teil des Substrats (413) bildet, wobei der PN-Übergang nahe an der Grenzfläche zwischen der dicken Isolierschicht (433) und der dünnen Isolierschicht (415) liegt.

17. Das Verfahren nach Anspruch 12, umfassend das Implantieren von Dotierungsmittel durch einen Boden des Grabens (19), um einen stark dotierten Bereich (73) angrenzend an den Boden des Grabens (19) auszubilden.

18. Ein Verfahren zur Herstellung eines MIS-Bauteils umfassend:
Bereitstellen eines Halbleitersubstrats von einem ersten Leitfähigkeitstyp;
Ausbilden eines Grabens (104) in dem Substrat, wobei der Graben eine Seitenwand und eine Bodenoberfläche aufweist, die eine Eckenfläche und eine zentrale Bodenfläche umfasst;
Abschneiden einer Nitridschicht in dem Graben (104);
Ätzen der Nitridschicht, um einen freigelegten Bereich an der zentralen Bodenfläche des Grabens (104) zu bilden; und
Aufheizen des Substrats und dadurch Aufwachsen einer Oxidschicht in dem freigelegten Bereich;
Entfernen der Nitridschicht;
Ausbilden einer relativ dünnen Gateoxid-Schicht auf wenigstens einem Teil der Seitenwand des Grabens (104);
Ausbilden eines Gates (102) in dem Graben (104), und Ausbilden eines Source-Bereichs (118) von einem ersten Leitfähigkeitstyp,
wobei das Wachsen einer Oxidschicht das Erzeugen eines Übergangsbereichs (108) umfasst, in dem eine Dicke der Oxidschicht allmählich in Richtung von dem freigelegten Bereich aus weg abnimmt, wobei das Verfahren ferner das Diffundieren von Dotierungsmittel von einem zweiten Leitfähigkeitstyp in das Substrat umfasst, wobei das Datierungsmittel einen PN-Übergang (114) mit einem rechtlichen Abschnitt des Substrats bildet,
**dadurch gekennzeichnet, dass**
das Diffundieren des Dotierungsmittels von dem zweiten Leitfähigkeitstyp das Kontrollieren der Diffusion des PN-Übergangs (114) umfasst, sodass der PN-Übergang (114) den Graben in dem Übergangsbereich (108) an der Eckenfläche der Bodenoberfläche des Grabens schneidet.

## Revendications

1. Dispositif métal-isolant-semiconducteur comprenant ;
un substrat semi-conducteur (13) comprenant une tranchée (19) s'étendant dans le substrat (13) depuis une surface du substrat (13), la tranchée (19) ayant une paroi latérale et une surface de fond comprenant une surface de coin et une surface de fond centrale ;
une région de source (11) ayant un premier type de conductivité jouxtant la paroi latérale de la tranchée (19) et la surface du substrat (13) ;
une région de corps (12) ayant un deuxième type de conductivité opposé au premier type de conductivité, jouxtant la région de source (11) ; et
une région de drain (N-épi) ayant le premier type de conductivité jouxtant la région de corps (12) et la surface de fond centrale de la surface de fond de la tranchée (19),
dans lequel la tranchée (19) est revêtue avec une première couche isolante (15) qui jouxte la paroi latérale et la surface de coin et avec une deuxième couche isolante (33) qui jouxte la surface de fond centrale de la tranchée, la deuxième couche isolante (33) étant plus épaisse que la première couche isolante (15) ;
**caractérisé en ce que**
la région de corps (12) jouxte à la fois la paroi latérale et la surface de coin de la surface de fond de la tranchée (19).

2. Dispositif selon la revendication 1, comprenant en outre une région de grille (14) couplée à la première couche isolante (15) et à la deuxième couche isolante (33) à l'intérieur de la tranchée (19).

3. Dispositif selon la revendication 1, comprenant en outre une région de conductivité élevée (73) ayant le premier type de conductivité formée dans la région de drain (N-épi) jouxtant la surface de fond centrale de la surface de fond de la tranchée (19).

4. Dispositif selon la revendication 1, dans lequel la première couche isolante (15) s'étend jusqu'à l'interface entre la surface de coin de la surface de fond et la surface de fond centrale de la surface de fond de la tranchée (19).

5. Dispositif selon la revendication 4, dans lequel la région de corps (12) s'étend jusqu'à l'interface entre la surface de coin de la surface de fond et la surface de fond centrale de la surface de fond de la tranchée (19).

6. Dispositif selon la revendication 4, dans lequel la région de corps (12) s'étend jusqu'à une première distance le long de la surface de coin de la surface de fond de la tranchée (19).

7. Dispositif selon la revendication 1, dans lequel la première couche isolante (15) comprend une couche isolante de type oxyde.

8. Dispositif selon la revendication 1, dans lequel la deuxième couche isolante (33) comprend une couche isolante de type oxyde ou multicouche.

9. Dispositif semi-conducteur comprenant
un substrat semi-conducteur comprenant une tranchée (104) s'étendant dans le substrat depuis une surface du substrat, la tranchée (104) ayant une paroi latérale et une surface de fond comprenant une surface de coin et une surface de fond centrale ;
une région de source (118) ayant un premier type de conductivité jouxtant la paroi latérale de la tranchée (104) et la surface du substrat ;
une région de corps (112) ayant un deuxième type de conductivité opposé au premier type de conductivité, jouxtant la région de source (118) ; et
une région de drain (N-épi) ayant le premier type de conductivité jouxtant la région de corps (112) et la surface de fond centrale de la tranchée (104),
dans lequel la tranchée (104) est revêtue avec une couche d'oxyde comprenant une première section (106) jouxtant la surface de fond centrale de la surface de fond de la tranchée, une deuxième section (110) jouxtant la paroi latérale de la tranchée et une région de transition (108) entre les première et deuxième sections (106,110), la première section (106) jouxtant au moins une partie de la région de drain, la deuxième section (110) jouxtant au moins une partie de la région de corps (112),
l'épaisseur de la couche d'oxyde dans la première section (106) étant supérieure à une épaisseur de la couche d'oxyde dans la deuxième section (110), l'épaisseur de la couche d'oxyde dans la région de transition (108) diminuant progressivement de la première section (106) à ladite deuxième section (110),
**caractérisé par**
une jonction PN (114) entre la région de drain (N N-) et la région de corps (112) se terminant au niveau de la tranchée (104) jouxtant la région de transition (108) de la couche d'oxyde (106, 108, 110) au niveau de la surface de coin de la surface de fond de la tranchée.

10. Dispositif selon la revendication 9, comprenant une région fortement dopée (73) ayant le premier type de conductivité, jouxtant la surface de fond centrale du fond de la tranchée (104), la région fortement dopée (73) ayant une concentration de dopage supérieure à la concentration de dopage d'une partie du drain (N-) à l'extérieur de la région fortement dopée (73).

11. Procédé de fabrication d'un dispositif MIS, comprenant les opérations suivantes :
disposer d'un substrat semi-conducteur (413) ayant un premier type de conductivité ;
former une tranchée (419) dans le substrat (413), la tranchée (413) comprenant une paroi latérale et une surface de fond comprenant une surface de coin et une surface de fond centrale ;
déposer une couche isolante épaisse (433) sur la surface de fond centrale ;
former une couche isolante mince (415) sur la paroi latérale et sur la surface de coin ;
former une grille (414) dans la tranchée (419) ;
former une région de source (411) ayant un premier type de conductivité, et
diffuser un dopant (412) ayant un deuxième type de conductivité dans le substrat (413) le long de la paroi latérale ;
**caractérisé en ce que**
la diffusion du dopant (412) est poursuivie latéralement le long de la surface de coin de la surface de fond de la tranchée de façon à former une région de coin active de la tranchée (419).

12. Procédé selon la revendication 11, dans lequel la déposition de la couche isolante épaisse (433) comprend :
la déposition d'une couche de masque (456) sur la paroi latérale, la surface de coin, et la surface de fond centrale ;
la gravure de la couche de masque (456) pour exposer la partie de fond centrale de la tranchée (419) ;
la déposition d'une couche isolante épaisse (433) dans la tranchée (419) ;
la gravure de la couche isolante épaisse (433) pour former une partie exposée de la couche de masque (456) sur la paroi latérale tout en laissant une partie de la couche isolante épaisse (433) sur la surface de fond centrale de la tranchée (419) ; et
le retrait de la couche de masque (456) pour exposer la paroi latérale et la surface de coin de la tranchée (419) tout en laissant une partie de la couche isolante épaisse (433) sur la surface de fond centrale de la tranchée (419).

13. Procédé selon la revendication 12, dans lequel la couche de masque (456) comprend une couche de nitrure et dans lequel la formation de la couche isolante épaisse (433) comprend la croissance d'une couche d'oxyde (433) au moyen d'un traitement thermique.

14. Procédé selon la revendication 12, dans lequel la couche isolante mince (415) comprend une couche d'oxyde de grille.

15. Procédé selon la revendication 12, dans lequel la formation d'une grille (414) comprend la déposition de polysilicium dopé dans la tranchée (419) et la gravure du polysilicium dopé jusqu'à un niveau à peu près égal à une surface du substrat (413).

16. Procédé selon la revendication 11, dans lequel, après la diffusion, le dopant (412) forme une jonction PN avec une partie restante du substrat (413), la jonction PN étant située près d'une interface entre la couche isolante épaisse (433) et la couche isolante mince (415).

17. Procédé selon la revendication 12, comprenant l'implantation de dopant à travers le fond de la tranchée (19) pour former une région fortement dopée (73) adjacente au fond de la tranchée (19).

18. Procédé de fabrication d'un dispositif MIS, comprenant les étapes suivantes :
disposer d'un substrat semi-conducteur ayant un premier type de conductivité ;
former une tranchée (104) dans ledit substrat, la tranchée comprenant une paroi latérale et une surface de fond comprenant une surface de coin et une surface de fond centrale ;
déposer une couche de nitrure dans ladite tranchée (104) ;
graver ladite couche de nitrure pour former une zone exposée au niveau de la surface de fond centrale de ladite tranchée (104) ;
et chauffer le substrat et par conséquent faire croître une couche d'oxyde dans ladite zone exposée, en éliminant ladite couche de nitrure ;
former une couche d'oxyde de grille relativement mince sur au moins une partie de la paroi latérale de ladite tranchée (104) ;
former une grille (102) dans ladite tranchée (104), et
former une région de source (118) ayant un premier type de conductivité,
dans lequel la croissance d'une couche d'oxyde comprend la création d'une région de transition (108) dans laquelle l'épaisseur de la couche d'oxyde diminue progressivement dans une direction s'éloignant de ladite zone exposée,
le procédé comprenant en outre la diffusion de dopant ayant un deuxième type de conductivité dans ledit substrat, ledit dopant formant une jonction PN (114) avec une partie restante dudit substrat,
**caractérisé en ce que**
la diffusion de dopant ayant ledit deuxième type de conductivité comprend le contrôle de la diffusion de ladite jonction PN (114) de façon que ladite jonction PN (114) croise la tranchée dans ladite région de transition (108) au niveau de la surface de coin de la surface de fond de la tranchée.
